# EUROPEAN PATENT APPLICATION

(11) **EP 3 165 966 A1**
(43) Date of publication of application: **10.05.2017**
(21) Application number: 15193326.4
(22) Date of filing: 06.11.2015
(51) Int. Cl.: G03F 7/20, H01L 21/265

(54) **METHOD FOR SELECTIVE SURFACE PROCESSING BY MEANS OF DIRECTIONAL BEAMS**

(71) Applicant: Paul Scherrer Institut, 5232 Villigen (CH)
(72) Inventor: WORLE, Judith, 5200 Brugg (CH); CAMARDA, Massimo, 5200 Brugg (CH)
(74) Representative: Fischer, Michael

(57) **Abstract**

It is an objective of the present invention to provide a method for selectively processing the surface of a semiconductor substrate.

This objective is achieved according to the present invention by a method to selectively process a surface of a substrate, preferably a semiconductor substrate, comprising the steps of:
a) providing a substrate having an faceted surface defining sections with different surface orientation;
b) applying a directional beam to the faceted surface thereby recording higher intensities of the directional beam into regions being oriented more perpendicular to the directional beam as compared to respective other sections being oriented less perpendicular to the directional beam;
c) further selectively processing of the sections having received the higher intensities and/or of the section having received the lower intensities.

This method enables the generation of 'self-aligned' sections which depend on the local morphology of the faceted surface. The term "faceted surface" refers to surfaces having well separated regions with different surface orientations with respect to the averaged surface of the substrate. This term also includes for example undulated surfaces. The differences of the angles between the vector normal of the surface of the substrate and the incident beam will deliver different average beam exposurein the different sections of the faceted surface.

## Description

The present invention relates to a method for selective processing of the surface of a substrate by means of directional beams.

Producing semiconductor devices is a complex and cumbersome process that requires a number of surface processing steps, such as irradiating a photosensitive layer, etching of irradiated sections and further processing of the etched sections. For the production of the semiconductor chips, during the irradiation steps masks are used that provide a holographic or lithographic interference pattern according to the desired design of the semiconductor chip.

Holographic patterning methods are disclosed in the International Patent Application WO99/059035A1 as a technique that focus on a goal to selectively illuminate the surface of a semiconductor substrate, i.e. the creation of thin parallel stripes on the surface of a photosensitive polymer. The holographic patterning is independent of the surface of the substrate but depends on the setup of the exposure system.

Nevertheless, it would desirable to take advantage of the roughness of the surface of the semiconductor substrate during the irradiation.

It is therefore an objective of the present invention to provide a method for selectively processing the surface of a semiconductor substrate.

This objective is achieved according to the present invention by a method to selectively process a surface of a substrate, preferably a semiconductor substrate, comprising the steps of:
a) providing a substrate having an faceted surface defining sections with different surface orientation;
b) applying a directional beam to the faceted surface thereby recording higher intensities of the directional beam into regions being oriented more perpendicular to the directional beam as compared to respective other sections being oriented less perpendicular to the directional beam;
c) further selectively processing of the sections having received the higher intensities and/or of the section having received the lower intensities.

This method enables the generation of 'self-aligned' sections which depend on the local morphology of the faceted surface. The term "faceted surface" refers to surfaces having well separated regions with different surface orientations with respect to the averaged surface of the substrate. This term also includes for example undulated surfaces. The differences of the angles between the vector normal of the surface of the substrate and the incident beam will deliver different average beam exposure in the different sections of the faceted surface. In one preferred embodiment of the present invention these different surface orientations can be distinguished roughly into rather flat sections and rather steep sections, while the rather flat section are oriented more parallel to the averaged surface of the substrate hereinafter referred to as terrace sections and the rather steep sections are oriented more parallel to the vector normal of the averaged surface hereinafter referred to as riser sections.

Different exposure intensities and/or times will allow for the subsequent development of only part of the surface of the substrate, e.g. the irradiated sections of a photosensitive film. It has to be noted here that the exposure to the incident beam might not required a distinct further development. An ion beam might for example directly alter the surface sections receiving high intensities, e.g. by direct etching of some metal film or by implanting atoms (i.e. doping the semiconductor) according to the local surface profile. Subsequent development can in this case mean for example just to clear the treated surface sections.

Therefore, in a preferred embodiment of the present invention, the irradiation time for the terrace sections and the riser section can be different. E.g. the substrate is irradiated from a first direction with a beam irradiating rather the terrace sections during a first intervall, and the substrate is irradiated from a second direction with a beam irradiating rather the riser sections during a second intervall wherein the first intervall can be larger than the second intervall or vice versa.

Typically, the semiconductor substrate is monocristalline or polycristalline that can be optionally coated with some superficial layer to be processed by the directional beam, such as a photosensitive film.

Preferably, the substrate to be processed may present defined regions with different surface orientations with respect to the directional beam. The defined regions therefore allow a defined further processing.

In order to selectively control the intensities received during irradiation, different angles between the incident directional beam and the orientation of the faceted surface are enhanced by properly tilting the semiconductor substrate with respect to the incident directional beam. Active tilting can therefore change the direction of the beam relative to the substrate by achieving different orientations of the surface due to the tilting.

Preferably, the directional beam can be made of monocromatic or polycromatic light. Alternatively, the directional beam can be made of electrons or ions or atoms, too.

Further preferred embodiments of the present invention are listed in the other dependent claims.

Preferred embodiments of the present invention are hereinafter described in more detail with reference to the attached drawings which depict in:
- Figure 1: AFM analysis (left and center) and SEM analysis (right) of a step bunched Silicon Carbide surface;
- Figure 2: schematically the principle of the technique using a highly direction beam;
- Figure 3: schematically the differences between a standard planar MOSFET (left) and one using the presented technique to selectively fabricate the channel only on the terraces (right);
- Figure 4: schematically the differences between a standard vertical Power MOSFET (left) and one using the presented technique (right) to selectively fabricate the source only on the risers and the channel only on the terraces; and
- Figure 5: schematically an SEM image of the surface of a substrate prior to and post-processing.

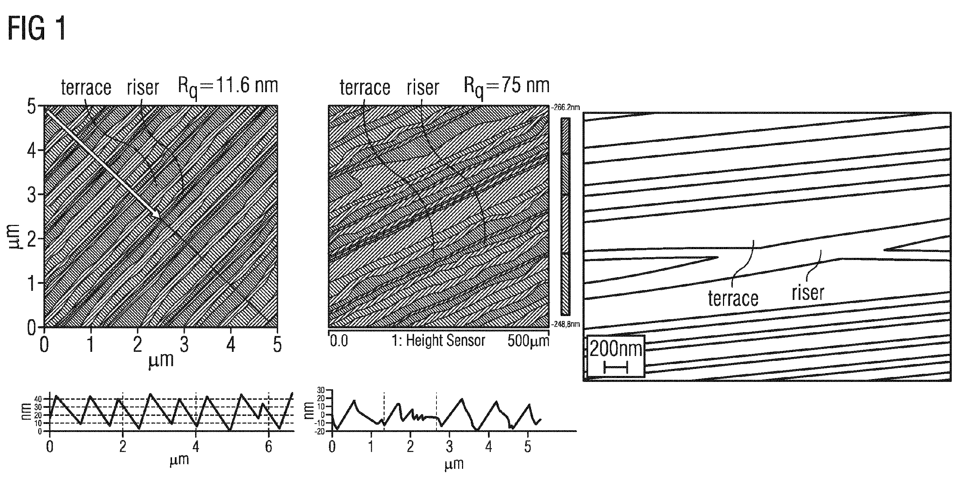

This present method allows for a localized processing of a faceted surface of a semiconductor substrate on the basis of the local surface profile. This applies to nano- and micro-undulated (sometimes called 'step bunched') semiconductor surfaces which present straight aperiodic variation of the surface height, ranging from few to hundreds ofnanometers (see Fig. 1).

The term "faceted surface" therefore comprises surfaces having a well separated local surface orientation which contains regions with different surface orientations with respect to the averaged surface of the substrate. This term also includes for example ondulated surfaces like the surface shown in Figure 1. Figure 1 shows an an AFM analysis (left and center) and an SEM analysis analysis of a step bunched Silicon Carbide surface. The two observable "facets",which are in the case of Silicon Carbide generally named terrace and riser, are indicated.

In the case of Silicon Carbide, terraces are regions whose surface coincide with the (0001) crystal plane (using the Miller index notation for hexagonal crystal structures), while riser sections are associated to large Miller indexes being tilted between few degrees to 90 degrees with respect to the (0001) crystal plane. This delivers with the shown orientation of the irradiating beam the result that terrace section receive substantially lower radiation intensities as compared to the riser sections which receive significantly higher radiation intensities (or vice versa depending on the angle of the incoming beam).

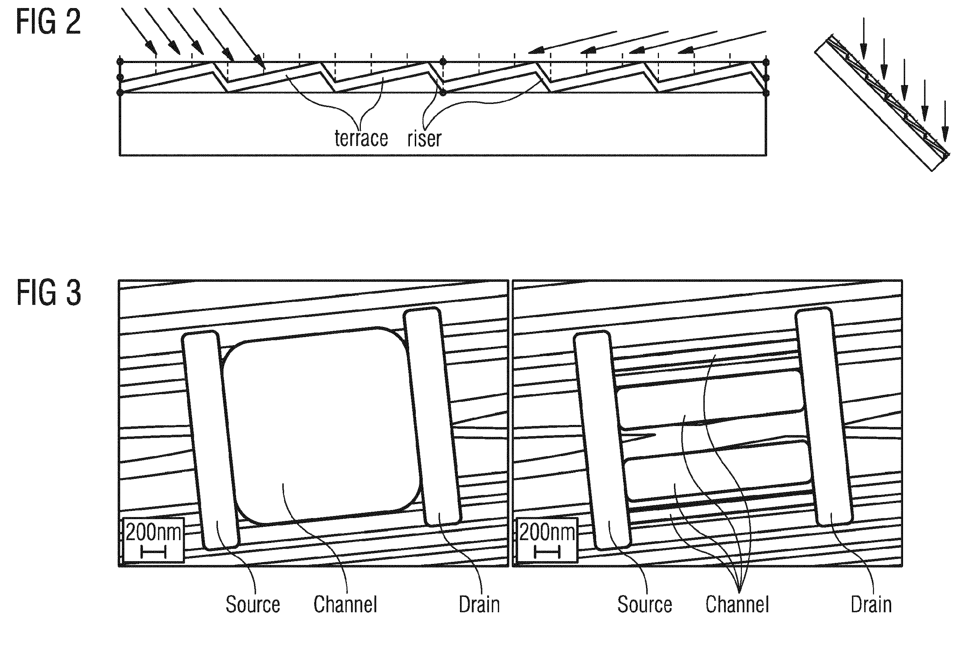

The method relies on the use of highly directional beams (using e.g. light or ions) to generate a shadowing effect which allows for an inhomogeneous (i.e. selective) exposure of the surface as principly shown in Figure 2. This allows, among the possible usages, to fabricate transistors whose channel lies only on one selected facet, either on the terrace, which corresponds to the [0001] miller index basal plane or on the riser, which is a high-density convolution of surface steps (see Figure 1, right side).

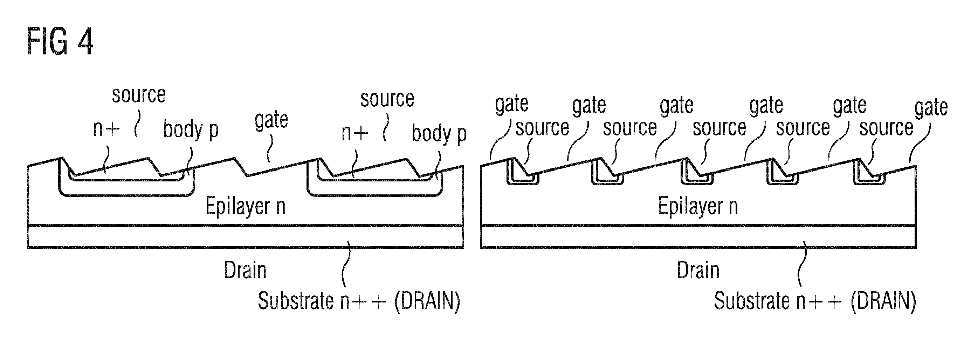

Figure 2 schematically shown examples of the present method. Depending on the direction of the beam (depicted as light grey or dark gray arrows) with respect to the surface facets some regions will be over-and others under-exposed, resulting in a selective processing. Figure 2, right, shows a schematic plot of how this technique has been applied on a mask aligner (SUESS MA 8) to obtain the selective exposure of a spinned resist for the POC (see Figure 4).

Silicon Carbide (SiC) power MOSFETs are currently affected by an excessively low channel mobility, which increases the on-state forward electrical resistance and switching losses thus decreasing the overall device efficiency. It is known that the oxide grown on terrace facets has superior qualities compared to that on the risers. The method proposed here can easily achieve this advantage by limiting the region of the MOSFET channel on the terrace facets only. A proper choice of the channel facet will reduce the total density of interface state traps on the channel and increase the carrier mobility resulting in an increase of the device efficiency, specifically, this will reduce the switching losses and the on-state resistance, thus the total energy consumption of the device.

Figure 3 schematically shows the differences between a standard planar MOSFET (left) and one using the presented technique to selectively fabricate the channel only on the terraces (right), where the density of interface traps is lower. It has to be noted that the reduction of the channel effective width is easly compensated by the increase of mobility on the terrace facets. It has also to be noted that this methodology could be applied also, in combination with standard self-aligned implantations, to select one surface facet for the gate and one facet for the source (on a vertical power MOSFET configuration, as schematically shown in Figure 4. Specifically, an initial tilted lithography allows to implant the source and body region within the risers. The same technique is used again two other times to deposit and define both the source and gate contacts. Finally, a standard lithography is used to define the external pads.

Figure 4 schematically illustrates the differences between a standard vertical Power MOSFET (left) and one using the presented technique (right)to selectively fabricate the source only on the risers and the channel only on the terraces. In both cases, the source and body are implanted using the same mask (self-aligned fabrication) but changing the implantation parameters or using spacers, this allows to precisely align the two regions with sub-micrometer size channels.

This fabrication innovation, by reducing the source areas, should result in an improvement of both the channel characteristics (since the channels will all be on the terraces) and on higher current capability for the same device area.Unlike standard techniques, this methodology applies to unprocessed samples i.e. does not require prior lithographic steps and it can easily be included within the standard device processing and, subsequently, readily verified by proper analysis of the final devices.

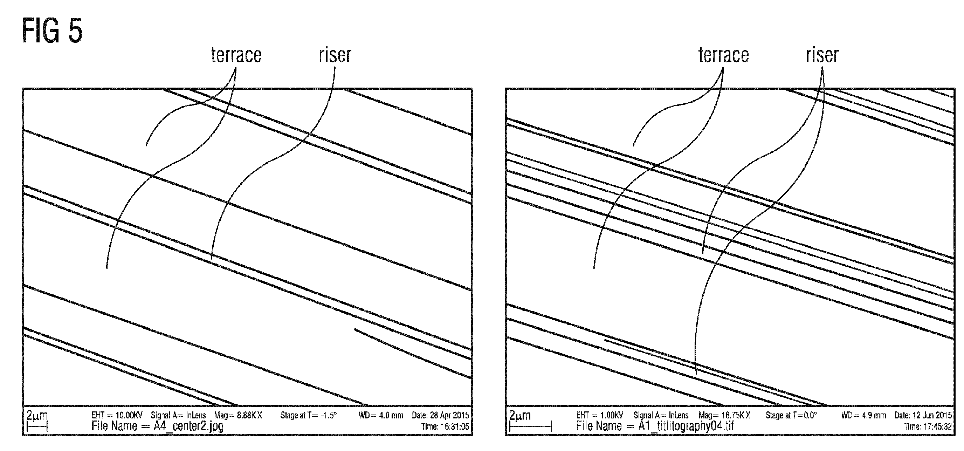

Presently, a Proof of Concept (POC) test has been performed using light beams (coming from a mask aligner) on a photosensitive polymer (resist). Figure 5 shows an SEM image of the surface prior- and post-processing, the brighter (no resist present) and darker (resist present) regions in the post-processed surface show the success of the technique (right). In detail, Figure 5 illustrates a pre- (left) and post- (right) tilted exposure under standard SUESS MA 8 mask aligner, the tilt angle (∼80 degrees) and the direction of the tilt allowed for selectively removing the resist on terraces only (brighter areas in Figure 5, right).

## Claims

1. A method to selectively process a surface of a substrate, comprising the steps of:
a) providing a substrate having an faceted surface defining sections with different surface orientation, such as e.g. terrace sections and riser sections;
b) applying a directional beam to the faceted surface thereby recording higher intensities of the directional beam into regions being oriented more perpendicular to the directional beam as compared to respective other sections being oriented less perpendicular to the directional beam;
c) further selectively processing of the sections having received the higher intensities and/or of the section having received the lower intensities.

2. The method according to claim 1 wherein the substrate is a semiconductor, said semiconductor substrate being monocristalline or polycristalline.

3. The method according to claim 1 or 2, wherein the substrate to be processed having the faceted surface comprises terraces sections and riser sections.

4. The method according to any of the preceding claims wherein different angles between the incident directional beam and the orientation of the undulated surface is enhanced by properly tilting the semiconductor substrate with respect to the incident directional beam.

5. The method according to any of the preceding claims wherein the directional beam is made of monocromatic or polycromatic light.

6. The method according to any of the preceding claims 1 to 4 wherein the directional beam is made of electrons or ions or atoms.

7. The method according to any of the preceding claims wherein the undulated surface is covered with a photosensitive film prior to the application of the directional beam.

8. The method according to any of the preceding claims wherein the surface is an undulated surface.
